Europäisches Patentamt

European Patent Office

Office européen des brevets

(11) Veröffentlichungsnummer: **0 346 974**
**A2**

(12) **EUROPÄISCHE PATENTANMELDUNG**

(21) Anmeldenummer: 89201473.9

(51) Int. Cl.⁴: **G01N 24/04**

(22) Anmeldetag: 08.06.89

(30) Priorität: 14.06.88 DE 3820169

(43) Veröffentlichungstag der Anmeldung:
20.12.89 Patentblatt 89/51

(84) Benannte Vertragsstaaten:
**DE FR GB NL**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB NL**

(72) Erfinder: **Leussler, Christoph Günter**
**Meldorfer Strasse 7**
**D-2000 Hamburg 20(DE)**
Erfinder: **Wichern, Andreas**
**Ehestorfer Weg 94a**
**D-2100 Hamburg 90(DE)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Hochfrequenz-Quadraturspulenanordnung für ein Kernresonanzuntersuchungsgerät.**

(57) Die Erfindung beschreibt eine Hochfrequenz-Quadraturspulenanordnung mit zwei Spulenpaaren aus je zwei Spulen, wovon jeweils nur eine mit dem Hochfrequenzsender- bzw. Hochfrequenzempfänger verbunden ist. Dabei ergeben sich hohe Betriebsgüten und eine gute Homogenität des Hochfrequenzfeldes.

FIG.1

## Hochfrequenz-Quadraturspulenanordnung für ein Kernresonanzuntersuchungsgerät

Die Erfindung betrifft eine Hochfrequenz-Quadraturspulenanordnung für ein Kernresonanzuntersuchungsgerät mit zwei um 90° gegeneinander versetzten, in einen Hochfrequenzempfänger oder einen Hochfrequenzsender anschließbaren Spulenpaaren, die aus je zwei gleichartigen, auf dem Umfang eines Zylinders um 180° gegeneinander versetzten Spulen mit parallel und senkrecht zur Spulenachse verlaufenden Leiterabschnitten bestehen.

Eine solche Hochfrequenz-Quadraturspulenanordnung ist aus der EP-PS 71 896 bekannt. Spulenanordnungen dieser Art können als Empfangsspule und/oder als Sendespule benutzt werden. Bei der Verwendung als Empfangsspule kann gegenüber einer konventionellen Spulenanordnung eine Verbesserung des Signalrauschverhältnisses um bis zu 3 dB erreicht werden, und bei Verwendung als Sendespule können damit zirkular polarisierte Hochfrequenzfelder erzeugt werden, wenn den beiden Spulenpaaren um 90° gegeneinander versetzte elektrische Spannungen zugeführt werden; dadurch reduziert sich der Sendeleistungsbedarf auf die Hälfte!

Bei der bekannten Anordnung ist jedes Spulenpaar resonant abgestimmt und an den Hochfrequenzsender bzw. den Hochfrequenzempfänger angeschlossen; jede Spule des Spulenpaares ist also mit dem Sender bzw. dem Empfänger verbunden. Dadurch können Mantelwellen auf den Zuleitungen entstehen, was eine Verringerung der Betriebsgüte zur Folge hat.

Aufgabe der vorliegenden Erfindung ist es, eine Hochfre quenz-Quadraturspulenanordnung in dieser Hinsicht weiter auszugestalten. Diese Aufgabe wird erfindungsgemäß dadurch gelöst, daß die beiden Spulen eines jeden Paares auf die gleiche Resonanzfrequenz abgestimmt sind und daß nur eine der Spulen eines jeden Spulenpaares an den Hochfrequenzempfänger bzw. den Hochfrequenzsender anschließbar sind.

Bei der Erfindung ist also nur jeweils eine der Spulen eines Spulenpaares an den Hochfrequenzempfänger bzw. Sender angeschlossen. Dabei wird die Tatsache ausgenutzt, daß die beiden Spulen eines Spulenpaares induktiv miteinander gekoppelt sind. Durch die Abstimmung jeder dieser beiden induktiv miteinander gekoppelten Spulen auf die gleiche Eigenresonanz wird ein Resonatorpaar gebildet, das zweier Schwingungsmoden fähig ist. In dem ersten Schwingungsmodus fließen die Ströme mit gleichem Umlaufsinn durch die beiden Spulen und im zweiten Schwingungsmodus werden die beiden Spulen eines Paares mit entgegengesetztem Umlaufsinn von einem Hochfrequenzstrom durchflossen. Bei dem ersten Schwingungsmodus ergibt sich im Innern des Spulenpaares ein homogenes Hochfrequenzfeld, und deshalb wird dieser Schwingungsmodus des Resonatorpaares ausgenutzt. Die Resonanzfrequenz dieses ersten Schwingungsmodus liegt unterhalb der Eigenresonanzfrequenz der beiden Resonatoren, während die Resonanzfrequenz des zweiten Schwingungsmodus oberhalb der Eigenresonanzfrequenz liegt. Um den ersten Schwingungsmodus auszunutzen, müssen daher die beiden Resonatoren - jeweils für sich allein - auf eine Eigenresonanzfrequenz abgestimmt sein, die soweit oberhalb der Betriebsfrequenz (das ist die Frequenz der mit der Spulenanordnung erzeugten Hochfrequenzimpulse bzw. der damit empfangenen Kernresonanzsignale) liegt, daß die Betriebsfrequenz mit der Resonanzfrequenz des ersten Schwingungsmodus zusammenfällt.

Weil jeweils nur eine der beiden Spulen eines Spulenpaares an den Hochfrequenzsender bzw. Hochfrequenzempfänger angeschlossen ist, können die hierfür erforderlichen Zuleitungen so kurz und so angeordnet sein, daß Mantelwellen und eine Verringerung der Betriebsgüte vermieden werden.

Bei der bekannten Spulenanordnung sind die beiden Spulenpaare innerhalb bzw. außerhalb eines isolierenden Trägerzylinders angeordnet. Die beiden Spulenpaare haben daher einen unterschiedlichen Abstand zu einem im Innern des Zylinder angeordneten Untersuchungsobjekt, so daß sie dadurch in unterschiedlicher Weise belastet werden und unterschiedliche Betriebsgüten aufweisen. Dadurch wird die Symmetrie gestört.

Eine bessere Symmetrie ergibt sich dadurch, daß die parallel zur Zylinderachse verlaufenden Leiterabschnitte beider Spulenpaare den gleichen Abstand von der gemeinsamen Zylinderachse aufweisen. Dabei werden die zur Zylinderachse parallelen Leiterabschnitte der Spulenpaare zweckmäßigerweise durch wenigstens zwei zur Zylinderachse senkrecht verlaufende und dazu konzentrische ringförmige Träger gehalten, die jeweils im gleichen Abstand von der Zylinderachse mit Ausnehmungen für die erwähnten Leiterabschnitte versehen sind.

In Weiterbildung dieser Ausgestaltung ist vorgesehen, daß die bogenförmigen, zur Zylinderachse senkrechten Abschnitte des einen Spulenpaares innerhalb und des anderen Spulenpaares außerhalb des durch die parallel zur Zylinderachse verlaufenden Leiterabschnitte definierten Zylindermantels angeordnet sind. Dadurch haben die bogenförmigen Leiterabschnitte des einen Spulenpaares zwar einen etwas größeren Radius als die des anderen, jedoch sind die Unsymmetrien zwischen den beiden Spulenpaaren dabei kleiner als bei der bekannten Anordnung.

Die Erfindung wird nachstehend anhand der Zeichnung näher erläutert. Es zeigen:

Fig. 1 eine erfindungsgemäße Spulenanordnung in perspektivischer Darstellung,

Fig. 2 einen zur Zylinderachse senkrechten Querschnitt durch eine solche Anordnung und

Fig. 3 den elektrischen Anschluß einer solchen Spulenanordnung.

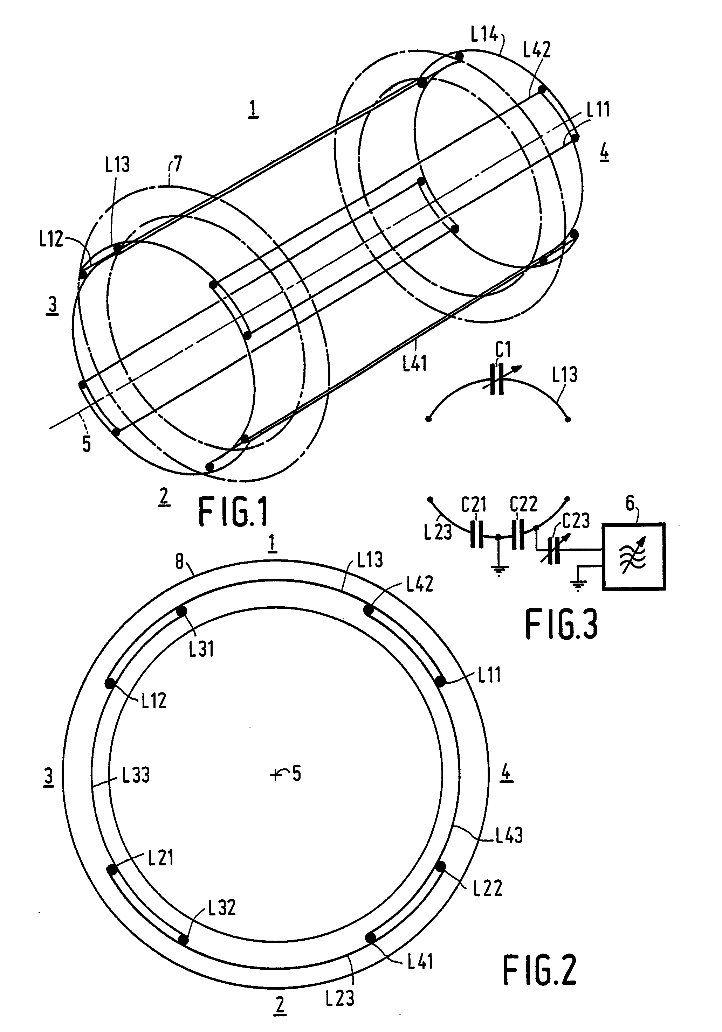

Wie aus den Figuren 1 und 2 hervorgeht, ist die Quadraturspulenanordnung rotationssymmetrisch ausgebildet. Diese Spulenanordnung ist im Innern eines nicht näher dargestellten Kernspinuntersuchungsgerätes so angeordnet, daß ihre Symmetrieachse 5 in Richtung des homogenen stationären Magnetfeldes verläuft, das in derartigen Untersuchungsgeräten erzeugt wird.

Die Spulenanordnung besteht aus zwei bezüglich der Symmetrieachse 5 um 90° gegeneinander versetzten Spulenpaaren 1, 2 bzw. 3, 4. Jedes Spulenpaar wiederum besteht aus zwei Spulen 1, 2 bzw. 3, 4, die um 180° gegeneinander versetzt angeordnet sind. Jede dieser insgesamt vier Spulen besitzt zwei parallel zur Symmetrieachse verlaufende gerade Leiterabschnitte L11...L41, L12...L42. Diese Leiterabschnitte L11...L41, L12...L42 sind gleich weit von der Symmetrieachse 5 entfernt, d.h., sie definieren einen Zylindermantel mit der Achse 5 als Zylinderachse. Die geraden Leiterabschnitte werden von wenigstens zwei ringförmigen Trägerkörpern 7, 8 gehalten, deren Mittelpunkte auf der Achse 5 liegen und die senkrecht zu dieser Achse angeordnet sind. Die Trägerkörper bestehen aus isolierendem Material (Kunststoff).

Die Enden der beiden zu einer Spule gehörenden Leiterabschnitte sind durch bogenförmige Leiterabschnitte miteinander verbunden; so werden beispielsweise die Enden der Leiterabschnitte L11 und L12, die zu der Spule 1 gehören, durch die bogenförmigen Leiterabschnitte L13 und L14 miteinander verbunden. Diese Leiterabschnitte, die in zur Achse 5 senkrechten Ebenen liegen, beschreiben bei sämtlichen Spulen einen Bogen von 120° um die Achse 5. Die vier bogenförmigen Leiterabschnitte (L13...L43), die sich auf jeweils einer Seite der Spulenanordnung befinden, können daher nicht gleichzeitig in derselben Ebene liegen und im gleichen Abstand von der Achse 5 angeordnet sein. Diese Leiterabschnitte sind daher zwar in der gleichen Ebene angeordnet, jedoch sind die Leiterabschnitte L33 und L43 des einen Spulenpaares 3, 4 innerhalb und die bogenförmigen Leiterabschnitte L13, L23 außerhalb des durch die geraden Leiterabschnitte L11...L42 definierten Zylindermantels angeordnet. Damit in diesem Fall beispielsweise der zur Spule 1 gehörende bogenförmige Leiterabschnitt L13 nicht mit den zu den Spulen 3 und 4 gehörenden geraden Leiterabschnitten L31 und L42 in elektrischen Kontakt kommt, sind zwischen die nicht zusammengehörenden Leiterabschnitte (z.B. L13 und L31 oder L13 und L42) nicht näher dargestellte Isolierscheiben eingefügt.

Fig. 3 zeigt den elektrischen Anschluß eines Spulenpaares 1, 2. Die Spule 1 enthält in der Mitte der beiden bogenförmigen Leiterabschnitte L13 und L14, von denen in Fig. 3 nur der Abschnitt L13 dargestellt ist, je einen Abstimmkondensator C1. Die mit der Spule 1 zusammen ein Spulenpaar bildende Spule 2 besitzt in der Mitte der entsprechenden Leiterabschnitte Abstimmkondensatoren der gleichen Größe. Einer dieser Leiterabschnitte - im Beispiel nach Fig. 3 der Abschnitt L23 - ist aber an einen Hochfrequenzsender (oder einen Hochfrequenzempfänger) 6 angeschlossen, wobei die Kapazität in der Mitte des Leiterabschnitts durch mehrere Kondensatoren gebildet wird. Dementsprechend sind in der Mitte des einen bogenförmigen Leiterabschnittes (in diesem Fall L23) zwei Kondensatoren C21 und C22 in Serie geschaltet, deren gemeinsamer Verbindungspunkt geerdet ist. Der von diesem Punkt abgewandte Anschluß des Kondensators C22 ist über einen Abstimmkondensator C23 mit einem Hochfrequenzgenerator oder einem Hochfrequenzempfänger 6 verbunden. Der Kondensator C23 liegt über dem niedrigen Innenwiderstand (50 Ohm) des Senders bzw. Empfängers 6 praktisch parallel zum Kondensator C22. Deshalb entspricht die Summe der Kapazitäten C22 und C23 etwa der Kapazität C21. Aus Symmetriegründen ist ferner die Kapazität des Kondensators C21 etwa doppelt so groß wie die Kapazität des Kondensators C1.

Wie aus Fig. 3 ersichtlich, ist nur die eine der beiden Spulen eines Spulenpaares an den Hochfrequenzsender bzw. -empfänger angeschlossen. Die andere Hochfrequenzspule ist mit ihr jedoch induktiv gekoppelt. Jede Spule bildet mit den in ihr enthaltenen Kondensatoren einen Resonator. Das auf diese Weise gebildete gekoppelte Resonatorpaar kann in zwei verschiedenen Schwingungsmoden schwingen. Bei dem ersten Schwingungsmodus werden die Resonatoren von Hochfrequenzströmen mit gleichem Umlaufsinn durchflossen. Bei dem zweiten Schwingungsmodus durchfließen die Hochfrequenzströme die Hochfrequenzspulen mit entgegengesetztem Umlaufsinn. Der zweite Schwingungsmodus ruft im Innern des Resonatorpaares ein sehr inhomogenes Hochfrequenzmagnetfeld hervor, während der erste Schwingungsmodus ein weitgehend homogenes Hochfrequenzfeld erzeugt. Da bei Kernspinuntersuchungen die Homogenität des erzeugten Hochfrequenzfeldes gefordert wird, ist nur der erste Schwingungsmodus von Interesse. Die mit dem ersten Schwingungs modus verknüpfte Resonanzfrequenz liegt tiefer (und die mit dem zweiten Schwingungsmodus verknüpfte Resonanzfrequenz höher) als die Eigenresonanzfrequenz eines Resonatorsystems, d.h. die Frequenz, die sich ergibt, wenn keine Kopplung mit dem zweiten Resonator besteht. Infolgedessen müssen die beiden Resonatoren auf eine (Eigenresonanz-) Frequenz abgestimmt sein, die oberhalb der für die Kernspinresonanz erforderlichen Betriebsfrequenz liegt, damit die Resonanzfrequenz für den ersten Schwingungsmodus mit der Betriebsfrequenz zusammenfällt.

Wenn beispielsweise die Quadraturspulenanordnung in einem für eine Induktionsflußdichte von 0,5 T ausgelegten Kernspinuntersuchungsgerät arbeiten soll, beträgt die Betriebsfrequenz etwa 21,3 MHz. Die Resonanzfrequenz für den ersten Schwingungsmodus liegt bei dieser Betriebsfrequenz, wenn die einzelnen Resonatoren auf eine Eigenresonanz von etwa 21,8 MHz abgestimmt werden; die Frequenz des unerwünschten zweiten Schwingungsmodus würde dann bei etwa 22,3 MHz liegen.

Die Abstimmung und die Symmetrierung kann etwa auf folgende Weise erfolgen:

Es wird zunächst der an den Hochfrequenzsender bzw. -empfänger 6 angeschlossene Resonator für sich allein auf eine Frequenz von etwa 21,8 MHz abgestimmt. Die Spule 1 darf dabei entweder nicht die in den Figuren 1 und 2 dargestellte Lage einnehmen oder ihr Stromkreis muß unterbrochen sein, damit die sich ergebende Resonanzfrequenz der Eigenresonanz der Spule 2 entspricht. Wenn die Spule 2 korrekt auf die angegebene Frequenz von etwa 21,8 MHz abgestimmt ist, ergibt sich bei Speisung dieser Spule mit dieser Frequenz ein Strommaximum bzw. ein Strombauch in der Mitte ihrer geraden Leiter L21, L22. An der gleichen Stelle ergibt sich ein Spannungsknoten, sie wirkt daher als virtueller Erdpunkt. Wenn diese Stelle geerdet wird, ergeben sich daher keine Veränderungen des elektrischen Verhaltens, was sich z.B. in einer unveränderten Anzeige des Eingangsreflexionsfaktors der Spule auf einem geeigneten Meßgerät äußern kann.

Wenn die Eigenresonanzfrequenz den richtigen Abstand von der Betriebsfrequenz hat und wenn die Spule 2 in der erwähnten Weise auf die Eigenresonanzfrequenz abgestimmt ist, wird sich an der symmetrischen Feldverteilung der Spule 2 nichts ändern, wenn der Resonator 1 in seine aus Fig. 1 bzw. 2 ersichtliche Lage gebracht wird und die Spule 2 mit der Betriebsfrequenz (21,3 MHz) gespeist wird. Allerdings kann die Feldverteilung der Spule 1 noch unsymmetrisch sein. Auch hierbei kann aber eine symmetrische Feldverteilung dadurch erreicht werden, daß der Abstimmkondensator C1 solange variiert wird, bis sich in der Mitte der zugehörigen geraden Leiter L11 und L12 ein virtueller Erdpunkt ergibt. Dies kann wiederum mittels eines an die Spule 2 angeschlossenen Reflexionsfaktormeßgerätes, das den Reflexionsfaktor bei der Betriebsfrequenz bestimmt, überprüft werden.

Danach wird überprüft, ob das Hochfrequenzfeld bezüglich der Achse 5 symmetrisch ist. Bei einer symmetrischen Feldverteilung, bei der sich die beste Homogenität des Hochfrequenzmagnetfeldes ergibt, hat das Hochfrequenzmagnetfeld in der Mitte des Spulenpaares den Wert Null bzw. ein Minimum, wenn in die Spule 2 ein Hochfrequenzstrom mit der Resonanzfrequenz des zweiten Schwingungsmodus (22,3 MHz) eingespeist wird. Die Feldstärke im Zentrum kann mittels einer sogenannten Pickup-Spule bestimmt werden. Ergibt sich dabei, daß das Minimum bzw. die Nullstelle und damit die volle Symmetrie noch nicht erreicht ist, werden die Kondensatoren C1, mit denen die Spule abgestimmt wird, solange gegensinnig verändert, bis sich das gewünschte Minimum einstellt.

Bei einer in der Praxis erprobten Quadraturspule bestehen die geraden Leiter L11...L42 aus je einem 8 mm dicken, 360 mm langen Kupferrohr, das an seinen Enden in Richtung des Zylinderradius abgeplattet ist, damit der Abstand zwischen den bogenförmigen Leiterabschnitten der beiden Spulenpaare klein gehalten werden kann. Die geraden Leiterabschnitte sind auf dem Umfang eines Zylinders mit einem Durchmesser von 340 mm angeordnet. Die bogenförmigen Leiterstücke werden durch eine 1 mm dicke und 15 mm breite Kupferbahn gebildet. Dabei ergeben sich hohe Gütefaktoren (unbelastet ca. 650, bei Belastung durch einen Patienten ca 220) und geringe Verschiebungen der Resonanzfrequenz bei Belastung durch einen Patienten von etwa 10 KHz. Ein Nachstimmen des Resonanzkreises nach dem Einbringen des Patienten ist somit nicht unbedingt erforderlich.

Bei sorgfältiger Abstimmung ist die Kopplung zwischen den beiden Spulenpaaren gering. Sie beträgt weniger als 0,005. Die Homogenität des mit einer derartigen Quadraturspulenanordnung erzeugten Magnetfeldes ist sehr gut; bei Messung mit einer Aufnehmerspule auf der Symmetrieachse 5 schwankt die Magnetfeldstärke maximal um + 0,5 dB. In den Zuleitungen treten keine Mantelwellen auf.

Statt mit jeweils zwei Kondensatoren können die einzelnen Spulen auch mit nur einem Kondensator oder aber mit vier Kondensatoren abgestimmt werden, die ebenfalls symmetrisch angeordnet werden müssen. Bei Verwendung nur eines Kondensators muß dieser ebenfalls in der Mitte eines bogenförmigen Leiterabschnittes angeordnet sein, während bei Verwendung von vier Kondensatoren zu Abstimmzwecken die Kondensatoren zweckmäßigerweise an den vier Eckpunkten der Spule angeordnet werden, so daß sie jeweils das Ende eines geraden Leiterabschnittes (z.B. L11) mit dem Ende eines bogenförmigen Abschnittes (z.B. L13) verbinden. Die Verwendung von mehr Kondensatoren (mit größerer Kapazität) hat eine geringere Verschiebung der Resonanzfrequenz bei Einführen des Patienten zur Folge; jedoch wächst der Aufwand. Bei Verwendung nur eines Kondensators hingegen ergibt sich der umgekehrte Effekt.

Die Quadraturspulenanordnung sollte so bezüglich des Patienten angeordnet werden, daß die von den beiden Spulenpaaren erzeugten Felder unter einem Winkel von 45° zur Symmetrieebene des Patienten verlaufen. Andernfalls würden die Spulenpaare ungleich belastet und somit ungleiche Güten aufweisen.

## Ansprüche

1. Hochfrequenz-Quadraturspulenanordnung für ein Kernresonanzuntersuchungsgerät mit zwei um 90° gegeneinander versetzten, an einen Hochfrequenzempfänger oder einen Hochfrequenzsender anschließbaren Spulenpaaren, die aus je zwei gleichartigen, auf dem Umfang eines Zylinders um 180° gegeneinander versetzten Spulen mit parallel und senkrecht zur Spulenachse verlaufenden Leiterabschnitten bestehen, dadurch gekennzeichnet, daß die beiden Spulen (1,2 bzw. 3,4) eines jeden Paares auf die gleiche Resonanzfrequenz abgestimmt sind, und daß nur eine der Spulen (z.B. 2) eines jeden Spulenpaares (z.B. 1,2) an den Hochfrequenzempfänger bzw. den Hochfrequenzsender (6)anschließbar ist.

2. Hochfrequenz-Quadraturspulenanordnung nach Anspruch 1, dadurch gekennzeichnet, daß die parallel zur Zylinderachse verlaufenden Leiterabschnitte (L11..L41; L12..L42) beider Spulenpaare den gleichen Abstand von der gemeinsamen Zylinderachse aufweisen.

3. Hochfrequenz-Quadraturspulenanordnung nach Anspruch 2, dadurch gekennzeichnet, daß die bogenförmigen, zur Zylinderachse senkrechten Leiterabschnitte des einen Spulenpaares (3,4) innerhalb und des anderen Spulenpaares (1,2) außerhalb des durch die parallel zur Zylinderachse (5) verlaufenden Leiterabschnitte definierten Zylindermantels angeordnet sind.

4. Hochfrequenz-Quadraturspulenanordnung nach Anspruch 2, dadurch gekennzeichnet, daß die zur Zylinderachse (5) parallelen Leiterabschnitte (11..L41;L12..L42) von wenigstens zwei ringförmigen Scheiben (7,8) getragen werden.

L14

L42

1

L11

4

L13

7

L12

3

5

L41

C1

L13

2  FIG.1

1

8

L13

L42

L31

L12

L11

C21  C22

L23  C23

6

3

L33

5

4

L43

L21

L22

L32

L41

2  L23

FIG.2

FIG.3